(19) Europäisches Patentamt
European Patent Office
Office européen des brevets

(11) **EP 4 257 998 A1**

(12) **EUROPEAN PATENT APPLICATION**

(43) Date of publication:
**11.10.2023 Bulletin 2023/41**

(21) Application number: **22305459.4**

(22) Date of filing: **05.04.2022**

(51) International Patent Classification (IPC):
***G01R 33/12*** *(2006.01)*

(52) Cooperative Patent Classification (CPC):
**G01R 33/093; G01R 33/098; H01F 10/3286;**
G01R 33/0052; G01R 33/007

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Commissariat à l'énergie atomique
et aux énergies alternatives
75015 Paris (FR)**
• **Centre national de la recherche scientifique
75016 Paris (FR)**

• **Université Grenoble Alpes
38400 Saint-Martin-d'Hères (FR)**

(72) Inventors:
• **PALOMINO, Alvaro
38054 GRENOBLE CEDEX 9 (FR)**
• **DIENY, Bernard
38054 GRENOBLE CEDEX 9 (FR)**
• **SOUSA, Ricardo
38054 GRENOBLE CEDEX 9 (FR)**
• **PREJBEANU, Ioan-Lucian
38054 GRENOBLE CEDEX 9 (FR)**

(74) Representative: **Cabinet Camus Lebkiri
25 rue de Maubeuge
75009 Paris (FR)**

(54) **MAGNETORESTISTIVE SENSOR SENSITIVE TO AN OUT-OF-PLANE MAGNETIC FIELD**

(57) The invention has for object a magnetoresistive sensor (100) sensitive to an out-of-plane applied magnetic field comprising:
- a sensing layer (106);
- a reference layer (104) with a fixed magnetization, the direction of said fixed magnetization being perpendicular to the plane of said reference layer;
- a non-magnetic spacer layer (105) separating said sensing layer (106) and said reference layer (104);
said sensing layer (106) having spontaneously a magnetization vortex configuration in the absence of an applied magnetic field, the vortex core diameter varying in the presence of an applied magnetic field perpendicular to the plane of said reference layer (104).

**Fig. 3**

**Description**

## TECHNICAL FIELD OF THE INVENTION

The present invention belongs to the field of spintronic and concerns a magnetoresistive sensor sensitive to an out-of-plane component of a magnetic field. For ease of the description, the out-of-plane component of magnetic field will be named out-of-plane magnetic field or magnetic field perpendicular to the plane.

## TECHNICAL BACKGROUND OF THE INVENTION

Spintronic magnetic field sensors are used in a wide range of automotive, industrial or biomed
ical applications. (P. P. Freitas, R. Ferreira and S. Cardoso, 2016, "Spintronic Sensors," in Proceedings of the IEEE, vol. 104, no. 10, pp. 1894-1918).
These types of magnetoresistive sensors present several advantages compared to other alternatives such as Hall sensors, search coils, Giant magneto-impedance sensors, SQUIDs or fluxgates due to their combination of high sensitivity, compact size, low power consumption, compatibility with CMOS integration and low cost.
Spintronic sensors convert a magnetic field variation into a voltage or resistance change under dc or ac bias current. Such resistance change is based on the giant magnetoresistance (GMR) effect in spin-valves (SVs) or the tunnel magnetoresistance (TMR) in magnetic tunnel junctions (MTJs). Both magnetoresistive structures show variation in their electrical resistance as a function of the relative orientation between the reference layer (RL) of fixed magnetization and the sensing layer (SL) magnetization.
Vortex based magnetoresistive sensors are known to exhibit high saturation fields, which constitutes an attractive feature for applications with large dynamic range (Suess, D., Bachleitner-Hofmann, A., Satz, A. et al., 2018, "Topologically protected vortex structures for low-noise magnetic sensors with high linear range". Nat Electron 1, 362-370).
For certain applications such as speed or current sensors, a large linear range is an important feature since this reduces the required accuracy on the amplitude of the field that the bias magnets generate on the sensor. However, it also goes with a decrease in the sensor sensitivity.
The stability of the vortex structure results from a minimization of the total energy of the system which includes the exchange energy arising from the non-uniformity of the vortex structure, the magneto-static energy from dipolar interactions, the magneto-crystalline anisotropy energy and the Zeeman energy if an external field is applied. For certain geometries, the ground energy state of nanoscale cylinders favors a vortex configuration, as theoretically predicted (Metlov, K. L. and Lee Y., 2008, "Map of metastable states for thin circular magnetic nanocylinders ." Appl. Phys. Lett. 92, 112506 (2008)). At such geometries, the magneto-static energy overpowers the exchange energy, resulting in the formation of the vortex configuration which corresponds to an in-plane curling of the magnetic moments enabling in-plane flux closure with an out-of-plane magnetized vortex core to reduce the exchange energy cost which would be generated by a magnetic singularity at the center of the cylinder. In the common case used in prior art sensor, the thickness of the cylinder is much smaller than its diameter. In this situation, the diameter of the vortex core is given by the exchange length defined by

$$l_{ex} = \sqrt{\frac{A}{\frac{1}{2}\mu_0 M_S^2}}$$

. With commonly used materials such as Permalloy ($Ni_{80}Fe_{20}$), cobalt, iron, this length is typically of the order of 5nm. The area of the vortex core is consequently a very small fraction of the disk area. For instance, for a disk of diameter 1micron, the ratio of the core area to the disk area is of the order of $(5/1000)^2 = 2.5 \cdot 10^{-5}$.

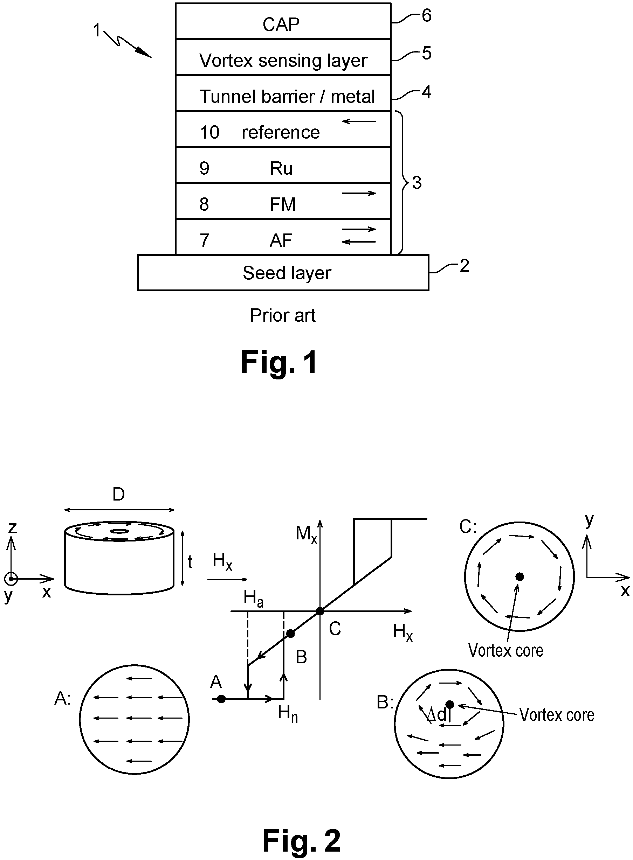

Prior art vortex-based sensors are sensitive to the in-plane component of the magnetic field. All along this description, "in-plane" means parallel to the plane of the stack layers of the sensor while "out-of-plane" or "perpendicular to the plane" mean along the normal to this plane. Figure 1 illustrates a magnetic stack configuration 1 of such prior art sensor.

The magnetic stack 1 successively includes:

- a seed layer 2;
- a pinned synthetic antiferromagnetic structure 3;
- a spacer 4 that may be either a tunnel barrier when the sensor is a magnetic tunnel junction or a nonmagnetic metallic spacer when the sensor is a metallic spin-valve;
- a sensing layer 5 which is spontaneously in magnetic vortex configuration in the absence of applied magnetic field;
- a capping layer 6.

The pinned synthetic antiferromagnetic structure 3 comprises successively:

- an antiferromagnetic layer (AF) 7 typically based on IrMn or PtMn alloys (for instance, $Ir_{20}Mn_{80}$ or $Pt_{50}Mn_{50}$);
- a ferromagnetic layer (FM) 8;
- a spacer layer 9 providing antiferromagnetic interlayer coupling (so-called RKKY coupling) between the two adjacent magnetic layers, this spacer layer being made for example of Ru ;
- a reference layer 10.

The reference layer 10 is part of a Synthetic Antiferromagnet ("SAF"). The SAF comprises two layers 8 and 10 antiferromagnetically coupled, separated by the metallic spacer 9. The two layers 8 and 10 are respectively considered as a reference (or polarizer) layer 10 and a pinned layer 8. The SAF is associated with the antiferromagnetic pinning layer 7 which provides exchange bias to the magnetic pinned layer 8 of the SAF in contact with it. The SAF is then grown above this antiferromagnetic pinning layer 7. Said pinned synthetic antiferromagnetic structure (AF/SAF) of the form (AF/FM/Ru/Reference) is commonly used as pinned reference electrode, where the layer FM 8 is a ferromagnetic material such as cobalt or an alloy mostly based on Fe, Co, Ni. When the sensor is a metallic spin-valve with a non-magnetic metallic spacer separating the reference layer from the sensing layer, the whole stack has usually a face centered cubic (fcc (111) texture). When the sensor is a magnetic tunnel junction, the spacer between the reference layer and the sensing layer is then an oxide tunnel barrier most often made of MgO bcc (001) texture. In this case, to grow a four-fold symmetry bcc (001) oxide tunnel barrier on top of a three-fold symmetry fcc (111) AF/SAF structure, the reference layer 10 usually consists of a composite trilayer comprising successively:

- a Co or CoFe layer in contact with the spacer layer 9 in Ru or Ir inducing the antiparallel RKKY (Ruderman-Kittel-Kasuya-Yoshida) coupling;
- a nanocrystalline or amorphous layer made of a material such as Ta, W, Mo or Hf able to ensure a structural transition between fcc and bcc structure while absorbing the amorphizing element (e.g., B) from the adjacent layer and providing interlayer ferromagnetic coupling,
- an amorphous CoFeB alloy in contact with the tunnel barrier 4. Such amorphous CoFeB layer crystallizes with the same crystallographic structure as the tunnel barrier during annealing at temperatures above 250°C, leading to large tunneling magnetoresistance values (TMR) as well known by the man skilled in the art.

The synthetic antiferromagnetic (SAF) configuration allows reducing the stray field exerted by this hard reference stack on the sensing layer and provides larger magnetic stability to the reference layer. The ferromagnetic reference layer has an in-plane magnetization and is exchange coupled with the layer of anti-ferromagnetic material. As well-known by a man skilled in the art, the ferromagnetic material layer 8 of the SAF adjacent to the antiferromagnetic layer 7 is pinned in an in-plane direction by annealing the stack and letting it cool down from above the blocking temperature of the antiferromagnetic layer under an externally applied magnetic field in that specific direction to saturate the ferromagnetic layer magnetization in that desired direction.

In vortex-based sensors sensitive to in-plane field, in a certain range of field limited by the vortex annihilation fields, an almost linear variation of resistance versus field is observed due to a lateral vortex core motion in a direction orthogonal to that of the in-plane field to be sensed. State of the art magnetoresistive sensors with a vortex configuration in the sensing layer are attractive due to their linear R(H) characteristics and stability of the vortex configuration.

The mechanism of operation of prior art vortex sensor is depicted in Figure 2. Figure 2 shows the magnetic response along the x axis (i.e., the direction of magnetization of the pinned reference layer) of the vortex sensing layer as a function of the field to be sensed, this field being applied in the plane of the layer along the x direction of magnetization of the pinned reference layer. At zero applied field (point C), the equilibrium state is a vortex configuration with the core positioned at the center of the disk (assuming no stray field from the reference stack). Under a given non-zero in-plane field H (point B), the vortex magnetization gets polarized along the field direction by a lateral shift of the vortex core in the direction perpendicular to the applied field direction. In Figure 2, the field is applied along the x-direction so that the vortex core shifts in the y-direction by a distance $\Delta d$ which results from a balance between the Zeeman energy, the exchange energy and the magnetostatic energy. The larger the field, the more shifted the vortex core. This yields linear M(H) and R(H) characteristics up to a certain characteristic field called the annihilation field (Ha), where the vortex structure totally annihilates and a single domain micromagnetic structure forms (A). On the way back from saturation, the vortex forms again at a characteristic magnetic field known as the nucleation field $(H_n)$.

One particular advantage of such known vortex-based sensors is a large linear range (40mT) compared to that of single domain elliptical sensors (5mT) which represents an eight-fold enhancement in sensing range but a decrease in sensitivity by the same factor as reported by Suess, D., Bachleitner-Hofmann, A., Satz, A. et al., 2018, "Topologically protected vortex structures for low-noise magnetic sensors with high linear range". Nat Electron 1, 362-370.

A drawback of this type of sensor is their noise. This noise results from the trapping of the vortex core in its lateral motion due to local fluctuations of the anisotropy. This can in particular occur in magnetic tunnel junction due to spatial variations of interfacial anisotropy at the interface between the oxide tunnel barrier and sense layer. Indeed, it is known that this anisotropy is very sensitive to parameters such as local oxygen or boron concentration. Since the vortex core has a small area in prior art vortex sensors (typically 5nm in diameter), the trapping can be very effective even on small defects of the order of a few nm such as grain boundaries. This may induce the equivalent of Barkhausen noise known in domain wall propagation but here for vortex core propagation. This noise impacts the signal to noise ratio of this type of sensors.

In addition, these sensors are sensitive to the component of the field parallel to the pinning direction of the reference layer magnetization, i.e., an in-plane direction. There is thus a limitation in the direction of measurement of the magnetic field.

In this context, the object of the present invention is to provide a vortex based magnetoresistive sensor able to measure the out-of-plane component of the field and presenting an improved signal to noise ratio.

## SUMMARY OF THE INVENTION

For this purpose, the invention proposes a magnetoresistive sensor sensitive to an out-of-plane applied magnetic field comprising:

- a sensing layer;
- a reference layer with a fixed magnetization, the direction of said fixed magnetization being perpendicular to the plane of said reference layer;
- a non-magnetic spacer layer separating said sensing layer and said reference layer;

said sensing layer having a magnetization vortex configuration in the absence of an applied magnetic field, the vortex core diameter varying in the presence of an applied magnetic field perpendicular to the plane of said sensing layer.

Thanks to the invention, it is possible to sense a magnetic field oriented perpendicular to the plane of the sensing layer in which the sensing layer is in a vortex micromagnetic configuration. The sensor principle is based on the expansion or contraction of the out-of-plane magnetized vortex core under the influence of the out-of-plane field to be sensed. By implementing such sensing layer in a magnetic tunnel junction or a spin-valve comprising an out-of-plane magnetized reference layer, this expansion/contraction of the vortex core produces a magnetoresistive signal which can be used to measure the amplitude of the applied field to be sensed. The obtained magnetoresistive sensor displays a large linear range and improved signal to noise ratios compared to prior art vortex-based sensors.

The sensor according to the invention exhibits an almost linear variation of resistance versus the amplitude of the out-of-plane field to be sensed. However, this linear variation is not associated with a lateral motion of the vortex core as in prior art sensor but on the expansion/contraction of the vortex core under the out-of-plane applied magnetic field. Due to the much larger size of the vortex core and the fact that the center of the core does not move laterally during field sensing, the noise of these sensors is much reduced resulting in higher signal to noise ratio compared to prior art vortex sensors.

In the present invention, as we will see further in the description, the ratio of the thickness of the sensing layer divided by the lateral dimension of the sensor is advantageously much larger than in prior art vortex sensor. This results in the vortex core being much wider than in prior art vortex sensor in which the diameter of the vortex core is given by the exchange length.

The sensor according to the invention may also present one or more of the characteristics below, considered individually or according to all technically possible combinations:

- the magnetoresistive sensor of the invention comprises means to apply a current through the sensor in the direction roughly perpendicular to the plane of the layers;
- the sensing layer is chosen with an aspect ratio defined as the thickness of the sensing layer divided by the in-plane characteristic dimension of the sensing layer comprised between 0.2 and 2 and advantageously between 0.2 and 1; when the sensor of the invention has a cylindrical shape with a circular cross section, the sensing layer in-plane characteristic dimension is its diameter. The invention however applies for any type of shape which allows stabilizing the vortex configuration of the sense layer. This is among other true for square shape, square shape with rounded corners, slightly rectangular shape (long side not exceeding twice the short side) possibly with rounded corners, elliptical shape with moderate ellipticity (not exceeding a ratio of 2 between long axis and short axis) or any other shape in which the vortex state can be stabilized. For all these shapes, the sense layer aspect ratio is defined by the ratio of its thickness by the shortest in-plane dimension. If the sense layer has a disk shape, this characteristic dimension is its diameter. If it is a square or close to a square, this is the length of the square side. If it is a rectangle, it is the short side of the rectangle. For an ellipse, it is the short axis of the ellipse.
- the non-magnetic spacer layer is a tunnel barrier layer or a metallic spacer;
- the reference layer is magnetically coupled to a synthetic antiferromagnetic layer with perpendicular anisotropy;
- the non-magnetic spacer layer is a tunnel barrier layer and the sensing layer comprises a first layer made of an alloy based on iron, cobalt and an amorphising element, said first layer being in contact with the tunnel barrier layer;
- the sensing layer comprises at least another layer of material adapted to absorb at least part of the amorphising element present in the first layer and to ensure a structural transition between the layers comprised in the sensing layer;
- the material adapted to absorb at least part of the amorphising element is chosen among the following materials: Ta, Mo, W, or Hf or a mixed of them;
- the sensing layer comprises one or several laminations oxide layers;
- the magnetoresistive sensor of the invention comprises an arrangement of one or more layers avoiding switching of the vortex core magnetization direction;

- the reference layer is magnetically coupled to a layer made in a hard material with perpendicular anisotropy;
- the magnetoresistive sensor of the invention comprises an antiferromagnetic layer inducing a perpendicular exchange bias on the sensing layer, said antiferromagnetic layer being magnetically coupled to the sensing layer;
- the magnetoresistive sensor of the invention comprises a non-magnetic spacer layer between the sensing layer and the antiferromagnetic layer inducing a perpendicular exchange bias on the sensing layer magnetization in order to tune the exchange bias coupling strength;
- the geometry and the dimensions of the vortex sensing layer are chosen such that the vortex configuration of the sensing layer is not annihilated over a range of applied magnetic field to be sensed of at least + or - 200 mT.

The invention has also for object a sensing device comprising a plurality of magnetoresistive sensors according to the invention that are electrically coupled in series and/or in parallel.

Said sensing device may comprise four magnetoresistive sensors according to the invention, said four magnetoresistive sensors being arranged according to a Wheatstone bridge configuration and configured so that the reference layer of the two sensors located in the two opposite branches of the bridge are magnetized in a first out-of-plane direction while the reference layer of the two magnetoresistive located in the two other branches of the bridge are magnetized in the opposite out-of-plane direction.

Other characteristics and advantages of the invention will clearly emerge from the description given below, for indicative and in no way limiting purposes, with references to the attached figures, among which:

- figure 1 illustrates a vortex sensor according to the prior art;
- figure 2 illustrates the mechanism of operation of the prior art vortex sensor of figure 1;
- figure 3 schematically illustrates a first embodiment of a sensor according to the invention;
- figure 4 illustrates the mechanism of operation of the vortex sensor of figure 3;
- figure 5 shows a detailed embodiment of the stack of the sensor of figure 3;
- figure 6 illustrates the dependance of the electrical resistance of the sensor of figure 5 as a function of the external magnetic field applied perpendicular to the plane of the magnetic stack;
- figure 7 a shows a transversal section view of the magnetization reversal of a magnetic element of 60nm diameter, 60nm thickness and magnetic saturation of 0.8 MA/m performed by micro magnetic simulations;

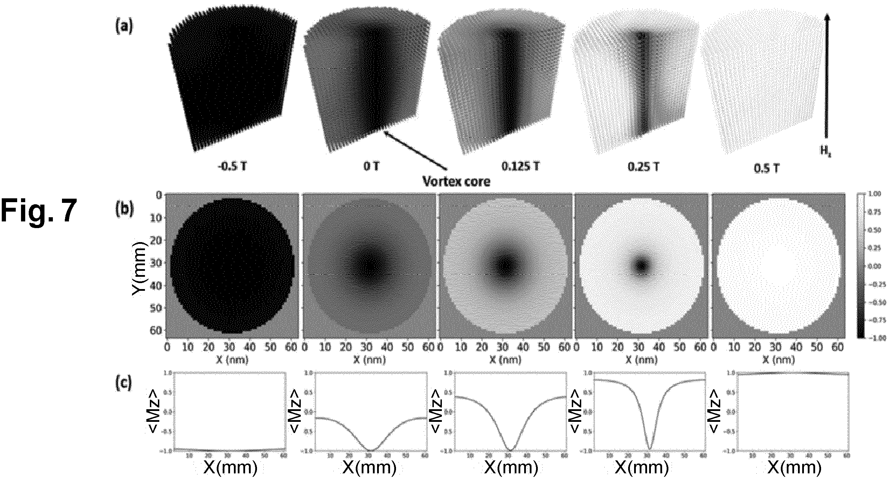

- figure 7 b shows 2D view of the Mz component of the uppermost superficial layer at the same external fields applied in figure 7 a;
- figure 7 c shows an 1D view of the Mz component of the uppermost superficial layer at y=0;

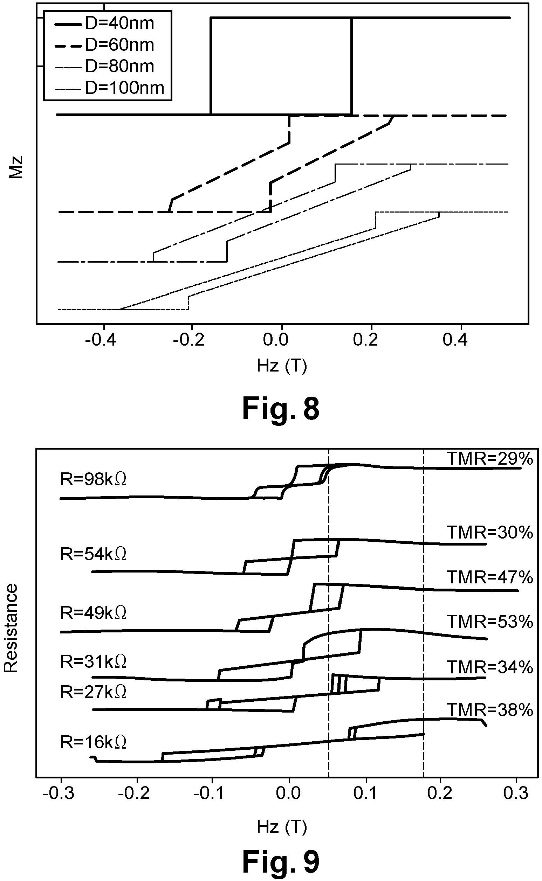

- figure 8 shows the evolution of the magnetization Mz as a function of the applied out-of-plane magnetic field Hz for different diameters D of the sensing layer;
- figure 9 shows electrical results of different nanopatterned sensors with different diameters;

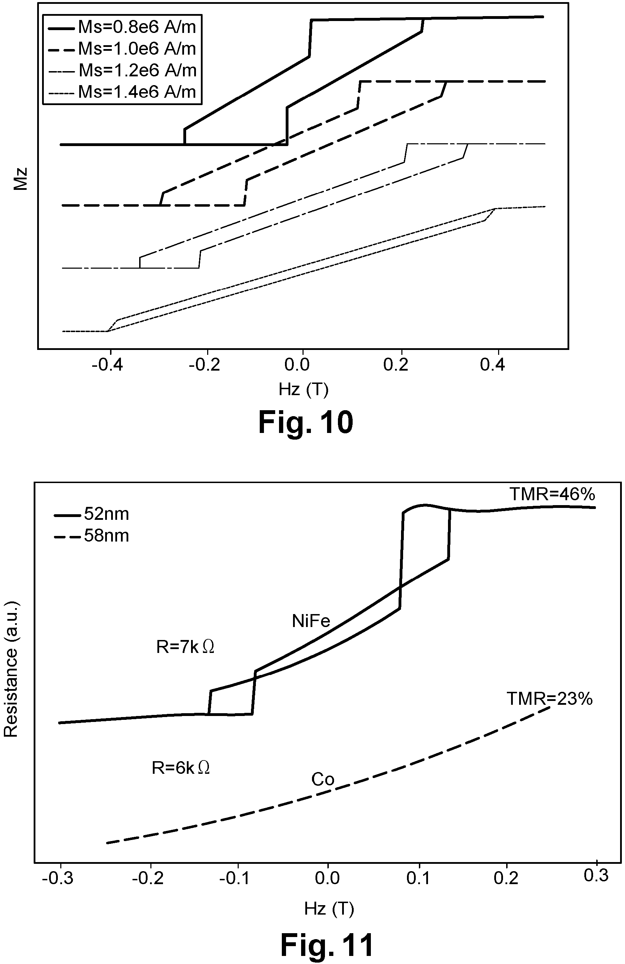

- figure 10 shows micromagnetic simulations of the reversal of a cylinder of 60nm thickness and 60nm diameter with $A_{ex}=13\times10^{-12}$ J/m$^2$ and $\alpha$=0.01 for different saturation magnetization values;
- figure 11 shows the evolution of the electrical resistance of two sensors, one with NiFe material (Ms=0.756 MA/m) as sensing layer material and the other with Co material (Ms=1.44 MA/m) as sensing layer material, with similar diameter, as a function of the applied out-of-plane magnetic field;

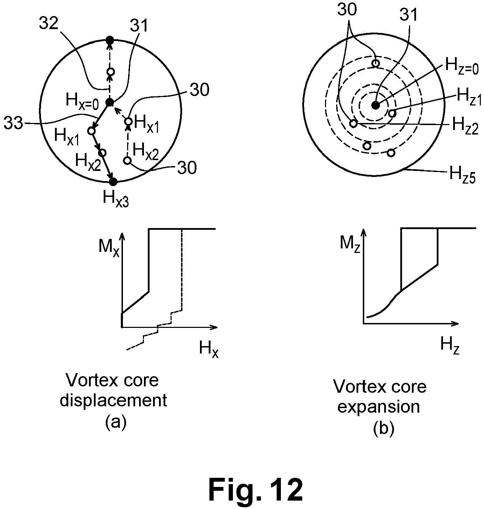

- figures 12 a and b respectively shows :

  ◦ schematic representation of the path followed by the magnetic vortex core for a prior art vortex sensor, during the displacement in the presence of interfacial defects under an external applied field in the plane of the layers and its consequent magnetization response and;
  ◦ schematic representation of the expansion followed by the magnetic vortex core for the vortex sensor of the invention, in the presence of interfacial defects under an external applied field perpendicular to the plane of the layers and its consequent magnetization response;

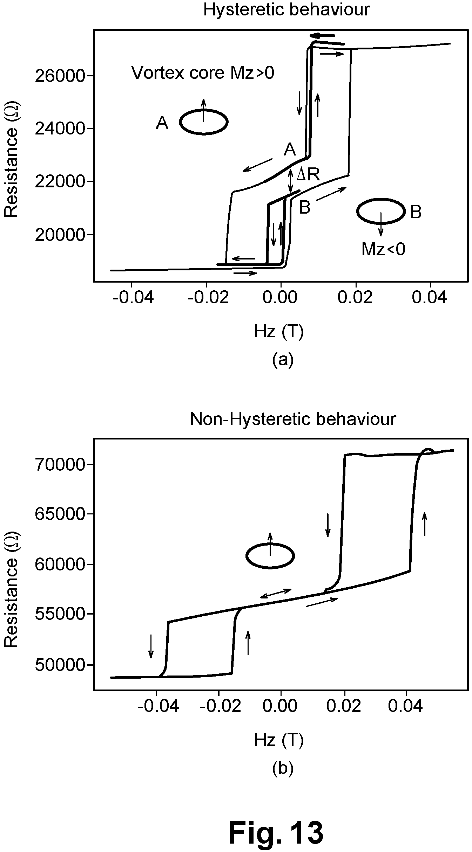

- Figure 13 a shows experimental hysteretic behavior observed in a sensor due to the vortex core polarity change;
- Figure 13 b shows non-hysteretic behavior in a sensor of the invention attributed to the presence of a stray field from the non-fully compensated SAF structure that stabilizes the vortex core polarity in a specific direction;

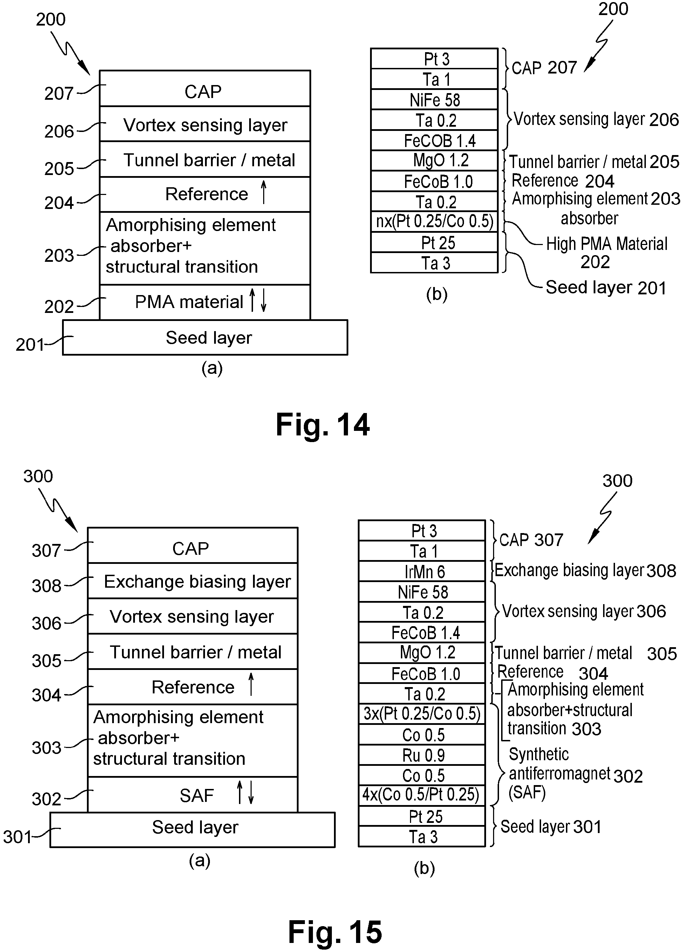

- Figures 14 a and b shows respectively a schematic and detailed representation of a magnetoresistive sensor of the invention with an uncompensated magnetic reference layer magnetized in the direction perpendicular to the plane of the multilayers;
- Figure 15 shows respectively a schematic and detailed representation of a magnetoresistive sensor of the invention with a compensated magnetic reference layer magnetized in the direction perpendicular to the plane of the layers and a top exchange biasing layer;

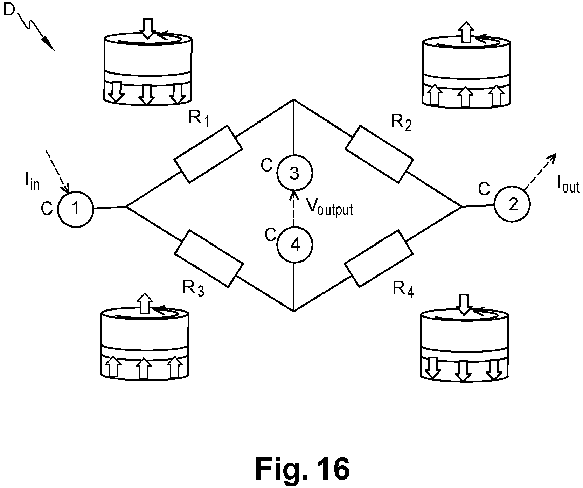

- Figure 16 shows a sensing device of the invention in a Wheatstone bridge configuration comprising four elementary magnetoresistive sensors of the invention.

## DETAILED DESCRIPTION OF AT LEAST ONE EMBODIMENT OF THE

## INVENTION

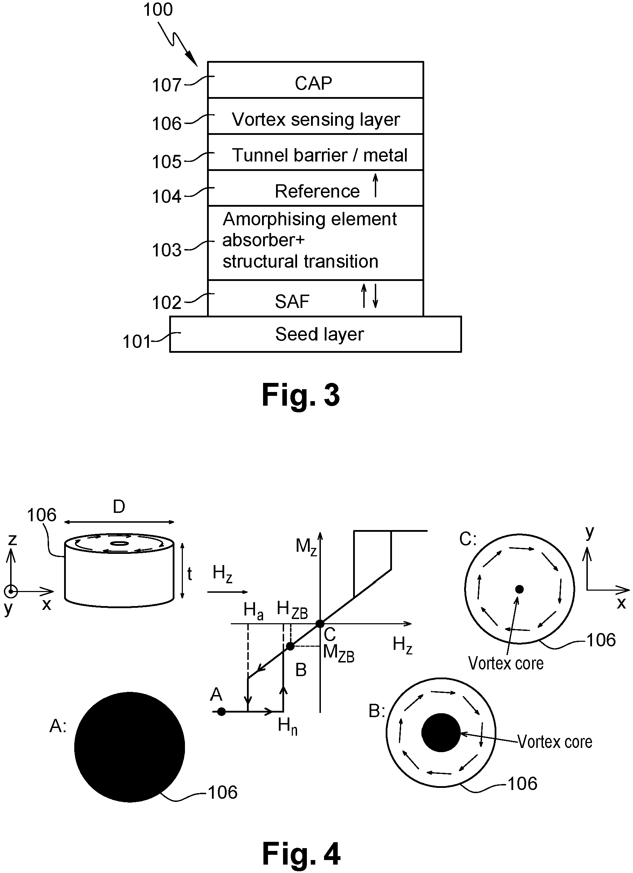

Figure 3 schematically illustrates a first embodiment of a sensor 100 according to the invention.

Said sensor 100 is a magnetic stack successively including:

- a seed layer 101;
- a synthetic antiferromagnetic structure 102;
- a texture breaking layer 103;
- a reference layer 104;
- a spacer 105 that may be either a tunnel barrier when the sensor is a magnetic tunnel junction or a non-magnetic metallic spacer when the sensor is a metallic spin-valve;
- a sensing layer 106 which is spontaneously in magnetic vortex configuration in the absence of applied magnetic field ;
- a capping layer 107.

The above magnetic stack has the form of a pillar, the cross section of which having advantageously a circular form.

As mentioned above, the sensing layer 106 has a magnetization vortex configuration. Besides, the sensing layer 106 exhibits an aspect ratio (i.e., thickness divided by in-plane characteristic dimension, here, the diameter) between 0.2 and 2 and advantageously, between 0.2 and 1. In contrast to prior art vortex sensor, the aspect ratio of the sense layer in this sensor is much closer to 1. As a result, the vortex is here much more confined within a narrow cylinder than it is in prior art in-plane sensitive sensors. Unexpectedly, due to this confinement, the vortex core turns out to be significantly larger than in prior art vortex sensors. Moreover, as we will see it with respect to figure 4, the vortex core diameter strongly varies when an out-of-plane field is applied to the device which is not the case in prior art vortex sensor.

The reference layer 104 has a fixed mono-domain magnetization perpendicular to the plane of the reference layer 104. The reference layer RL is most often used with a Synthetic Antiferromagnet ("SAF") 102, as shown at Figure 3. However, the invention does not necessarily need a SAF.

The sensing layer 106 in vortex configuration is part of a magnetoresistive element. The magnetoresistive element can be either a tunnel junction or a giant magnetoresistance metallic stack. In both cases, the element comprises a top and a bottom electrode so that a current can flow throughout the device in a direction roughly perpendicular to the plane of the layers. As well known by the man skilled in the art, the requirements on the nature of the layers are different in a magnetic tunnel junction and in a fully metallic giant magnetoresistance stack. Indeed, in a tunnel junction, different crystallographic structures are present in the stack (body centered (bcc) close to the tunnel barrier and face centered cubic (fcc) in the bottom part and top part of the stack) whereas in the giant magnetoresistance stack, the structure can remain fcc throughout the whole stack.

In contrast to this prior art, the mechanism of operation of the sensor 100 of figure 3 is described with respect to figure 4.

Differently from prior art vortex-based sensors sensitive to in-plane field, the sensor 100 is intended to sense out-of-plane field. From physical point of view, instead of relying on a lateral in-plane shift of the vortex core upon application of an in-plane field, the sensor 100 of the invention relies on the expansion/contraction of the vortex core of the sensing layer 106 under an out-of-plane field Hz (i.e., along the z axis, the Oxy plane being the plane of the different layers of the sensor).

The magnetization response Mz along the z axis of the sensing layer 106 as a function of the out of plane component Hz of an applied magnetic field is depicted in the transfer curve of Figure 4 showing the magnetization Mz of the sensing layer 106 as a function of the z-axis component of the applied magnetic field Hz. As for the prior art magnetoresistive sensors, said transfer curve shows a linear response region and two characteristic fields along both his ascending and descending branches, the annihilation field Ha where the vortex core expands to the whole sensing layer area so that the micromagnetic configuration becomes single domain almost saturated in the out-of-plane direction, and a nucleation field Hn when the field is decreased from saturation where the vortex forms again.

As previously mentioned, in prior art vortex sensor, the sensing layer diameter is usually large, of the order of one or a few microns, at least an order of magnitude larger than the thickness of the sensing layer. As a result, the vortex core is quite narrow, with a diameter of a few nanometers given by the exchange length. On the other hand, advantageously, according to the invention, the vortex core diameter gets much wider in cylinders of smaller diameters, when the diameter gets closer to the film thickness. If the field is applied in the out-of-plane direction parallel to the vortex core magnetization, the core diameter tends to increase: this situation is illustrated by the state B compared to the state C where no field is applied. In state B, assuming that the magnetization of the vortex core direction along the z-axis is down (i.e., the z component of the magnetization of the vortex core is negative), the component Hz is parallel and in the same direction (Mz is negative) as the vortex core magnetization and the diameter of the vortex core diameter increases compare to its value at state A without applied field. On the contrary, if the field is applied antiparallel to the core magnetization, its diameter then decreases. One has further to note that, advantageously, the sensor of the invention should be used in its linear response range; in other words, preferably, the applied field should not be used above the annihilation field Ha where the vortex core expands to the whole sensing layer area as shown in state A of figure 4. We will come back to this question later in the description to show how to avoid such annihilation and keep the sensor in its linear response.

If this sensing layer 106 is implemented in a spin-valve or a magnetic tunnel junction comprising an out-of-plane magnetized reference layer 104, these variations in vortex core diameter of the sensing layer 106 yield a resistance variation in the range of field delimited by the positive and negative vortex annihilation fields. Based on the said variation of the resistance, one can have access to the value of the corresponding out-of-plane component of the applied magnetic field.

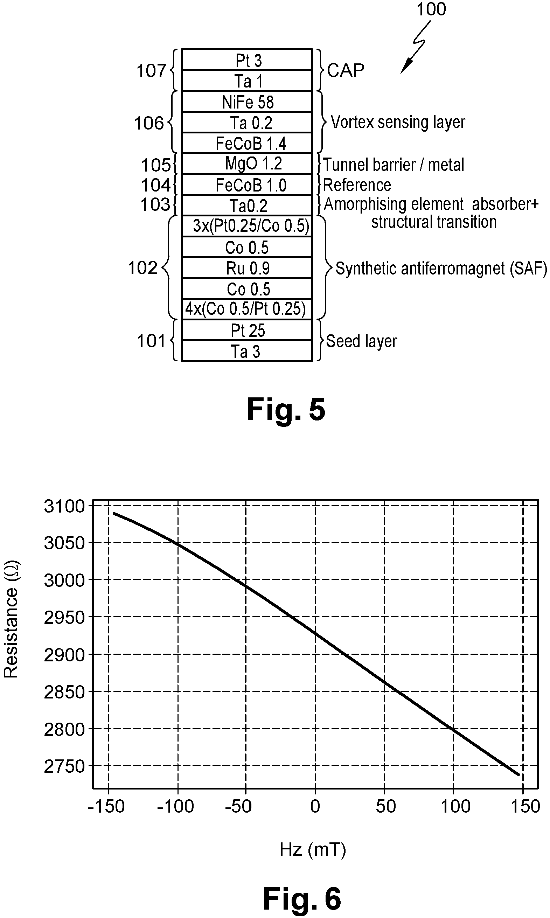

Figure 5 illustrates a first possible embodiment of the vortex sensor of the invention, in which the sensing layer is inserted in a magnetic tunnel junction whose reference layer is magnetized in the out-of-plane direction.

If the device is a magnetic tunnel junction, then the tunnel barrier 105 is an oxide or a nitride layer, such as MgO, AlOx, TiOx or AlN, TiN but preferably MgO which is known to provide large TMR signal. To get a large TMR with MgO (large TMR meaning typically a TMR above 80%, preferably above 140%, preferably above 200%), the MgO layer and the two magnetic electrodes sandwiching the MgO layer must have a crystalline bcc structure with (100) texture. As well known by the man skilled in the art, this can be realized by using as magnetic electrodes FeCoB layers which are amorphous as deposited but can recrystallize in bcc structure upon annealing at temperatures typically in the range 250°C to 400°C.

For this recrystallization to take place, the B or more generally the amorphising element contained in the FeCo based alloy must be expelled from this alloy. For that, a thin layer of a material capable of absorbing this amorphizing element is deposited next to the FeCo based layers on their interfaces opposite to the interfaces with the MgO layer. Such amorphizing element absorbing layer can be made of Ta, W, Mo or Hf for instance.

Taking into account the above consideration, the vortex sensing layer 106 can first comprise a thin FeCoB based layer in contact with the MgO barrier 105. In this layer, B is the amorphizing element. B could be substituted by other amorphizing element such as Zr or Nb. This first layer has typically a thickness in the range 1.5 to 5nm. This FeCoB is then in contact with a thin layer, a few angstroms thick, able to absorb the amorphizing element upon annealing of the structure. This layer can be made for instance of W, Mo, Ta. The sensing layer 106 further comprises a magnetic layer preferably made of a soft magnetic material such as Permalloy NiFe (composition close to Ni80Fe20) or a soft FeCo layer such as Co90Fe10 or an FeCoB alloy in order to minimize hysteresis in this layer when its micromagnetic configuration changes under the influence of the field to be sensed. This sensing layer 106 can also be a multilayer comprising several of such layers. The sensing layer 106 can also comprise thin laminations (thickness of the order of 0.1 to 0.5nm) of non-magnetic metals such as W, Mo, Ta, intended to absorb any amorphizing element or to break the grain growth to reduce the top roughness of the sensing layer. If the device is a magnetic tunnel junction, these laminations can also be made of oxide materials such as MgO, TaOx, AlOx, TiOx intended to induce some interfacial perpendicular anisotropy in the sense layer thereby allowing to slightly reduce the thickness of the sense layer. The product of resistance by the area (RA) of these oxide laminations should be then adjusted to values lower than the RA of the main barrier which is providing the tunnel magnetoresistance signal. This will avoid to excessively dilute the magnetoresistive signal due to the increased resistance caused by the introduction of these oxide laminations.

As already explained, the total thickness of this sensing layer is advantageously chosen with an aspect ratio (thickness divided by lateral dimension, here the diameter of the circular sensing layer) between 0.2 and 2 so that its micromagnetic equilibrium configuration is a vortex state with a core diameter significantly larger than the exchange length, preferably at least twice the exchange length (i.e., at least 10nm for material such as Permalloy or Co90Fe10). Examples of dimensions for the sensing layer are a thickness of the order of 60 nm to stabilize the vortex formation at zero field for diameters ranging between 50 and 200 nm, for instance 60 nm.

Micromagnetic simulations can be used to calculate the range of thicknesses which satisfy the condition of vortex configuration with vortex core diameter at least twice the exchange length.

Concerning the reference layer 104, its magnetization is fixed in the direction perpendicular to the stack of magnetic layers. This perpendicular configuration of the reference layer 104 is required since the measured magnetoresistance variation relies on the variation of the perpendicular magnetization Mz of the vortex-sensing layer 106. If the stack is an MgO based magnetic tunnel junction, this reference layer 104 is preferably made of an FeCoB alloy in contact with the MgO barrier 105. The magnetization of this reference layer 104 is maintained fixed out-of-plane by both the interfacial anisotropy which exists at the FeCoB/MgO interface and by exchange-like coupling with an out-of-plane magnetized multilayer such as (Co/Pt) multilayers. Other multilayers such as Co/X, where X is Pd, Ni or Ir, are well known by the man skilled in the art to provide large PMA (Perpendicular Magnetic Anisotropy) values. Alloys such as CoPt, CoPd or FePt or FePd ordered alloys or some rare earth transition alloys such as TbCo, TbFe can also provide strong PMA. This PMA multilayer or alloy can itself be part of a synthetic antiferromagnetic SAF layer 102 consisting of two antiferromagnetically coupled multilayers such as (Co/Pt) multilayers separated by a non-magnetic spacer typically of Ru or Ir whose thickness is adjusted to provide strong antiferromagnetic coupling between the two adjacent multilayers (typically 0.8nm for Ru spacer). This type of arrangement is well known by the man skilled in the art. It is also well known that such SAF structure may contain more than two antiferromagnetically coupled multilayers to further reduce the net stray field that the SAF and Reference layer exerts on the sensing layer. Since these PMA multilayers have a fcc structure while FeCoB is bcc after annealing, a thin structural transition layer 103 made of for instance Ta, Mo or W has again to be introduced between the FeCoB layer and the PMA multilayers. This layer 103 is also intended to absorb the amorphising element away from the FeCoB alloy upon annealing. In other words, the texture breaking layer 103 is introduced between the reference layer 104 in FeCoB in contact with the barrier 105 and the rest of the SAF 102 to insure a structural transition between the FeCoB layer which has to be body centred cubic (bcc with 4-fold symmetry) in the final device and the rest of the SAF which has generally a fcc structure with (111 texture) and 3-fold symmetry.

Besides, the SAF layer 102 is grown on a seed layer 101 to promote a (111) texture. The seed layer 101 can be a multilayer of the form Ta/Pt. The material used in the seed layer 101 is also usable for the capping layer 107.

Figure 6 illustrates experimental results showing the dependance of the electrical resistance of the sensor as a function of the external magnetic field applied perpendicular to the plane of the magnetic stack of the sensor represented in figure 5. Figure 6 shows that linear ranges up to more than 200mT can be obtained which are much larger than the already reported ones for prior art vortex sensors developed for in-plane field sensing (40mT or 80 mT).

Figure 7a shows a cross-section view of the evolution of the sensing layer magnetization under out-of-plane field as qualitatively described in Figure 5. The micromagnetic configurations represented in Figure 7a were obtained by micromagnetic simulations using micromagnetic simulation MuMax3 software. The simulations were performed on a cylinder of 60nm thickness and 60nm diameter with the following sensing layer parameters:

- saturation magnetization: $M_{sat} = 800 \times 10^3$ A/m,
- exchange stiffness: $A_{ex} = 13 \times 10^{-12}$ J/m$^2$.

Figure 7b represents a two-dimensional x-y view of the top layer magnetization during the reversal process. The mesh in the simulation has a cell size of 1nm. At H=0T, the vortex core is stabilized with a core here magnetized in the down direction. By increasing the field (see snapshots at 0.125T and 0.25T), the negatively magnetized core shrinks gradually and concomitantly, the in-plane curl magnetized cells become more and more polarized towards the out-of-plane applied field direction. Finally, the vortex is annihilated, and a single domain is observed above H=0.5T or below H=-0.5T.

The evolution of the magnetization value along the perpendicular direction Mz for the uppermost superficial layer (1nm cell) along a diameter of the cylindrical sensing layer is represented in Figure 7c.

The characteristic nucleation and annihilation fields can be controlled by varying the sensing layer diameter as shown in the micromagnetic simulations of Figure 8 showing the evolution of the magnetization Mz as a function of the applied out-of-plane magnetic field Hz for different diameters D of the sensing layer (respectively, D is equal to 40 nm, 60 nm, 80nm and 100 nm), using the same material parameters as in Figure 5. Figure 8 shows that for an element of 40nm in diameter, the reversal is abrupt between two single domain states, as the shape anisotropy (thickness of the sensing layer greater than diameter of the sensing layer) favors a single domain state along the longest dimension of the magnetic element which is here its thickness. However, for diameters of 60nm or larger, the vortex formation is observed, and the linear region along which the vortex is stable under external field expands with the sensing element diameter. In view of what precedes, the diameter (i.e., the characteristic length) of the sensing layer of the sensor according to the invention is thus greater or equal to the thickness of the sensing layer. One can see that increasing the diameter of the sensing layer allows increasing the range of the linear part of the response while decreasing the slope of the linear part of the response. Such diameter dependence allows creating sensor devices with large linear ranges only by increasing the diameter of the sensor. Besides, one can further see in figure 8, the presence of an hysteresis in the response of Mz versus Hz, said hysteresis showing up as two parallel linear responses separated by a constant magnetization difference. Advantageously, the sensor according to the invention shall be used either on one or the other of these two parallel linear responses. We will see later in the specification how to avoid switching from one linear part to the other for a single sensor according to the invention.

The simulations reported in Figure 8 are confirmed by the experimental results plotted in Figure 9 showing electrical results of different nanopatterned sensors with different diameters. Figure 9 shows the electrical resistance of the sensor as a function of the component Hz of the applied magnetic field. The different curves confirm the larger linear range predicted by simulations of the devices with smaller resistance (corresponding to larger diameter). The multilayer stack composition of the sensor deposited at room temperature by D.C. magnetron sputtering is the one shown in Figure 5:
Ta3/Pt30/4×[Co0.5/Pt0.25]
/Co0.5/Ru0.9/3×[Co0.5/Pt0.25]
/Co0.5/Ta0.2/FeCoB1.1/
MgO1.25/FeCoB1.4/Ta0.2/NiFe58/Ta1/Pt3.

The sample was subsequently annealed at 300°C for 10 minutes. The annihilation field represented by gray dots in Figure 9 gradually increases from 53 mT to 178 mT from the largest to smallest resistance junction meaning from smaller to larger diameters.

The characteristic nucleation and annihilation fields can also be controlled by varying the saturation magnetization Ms of the sensing layer. Figure 10 shows micromagnetic simulations of the reversal of a cylinder of 60nm thickness and 60nm diameter with $A_{ex}=13\times10^{-12}$ J/m$^2$ and $\alpha=0.01$ for different saturation magnetization (Ms) values. It is observed that the linear range, corresponding to the vortex stability region can also be tuned by modifying the saturation magnetization of the sensing material. Increasing the saturation magnetization Ms of the sensing layer allows increasing the range of the linear part of the response (by decreasing the slope of the linear part).

The increase of the linear range with increasing Ms is experimentally confirmed as observed in Figure 11, when comparing two sensor devices, one with NiFe material (Ms=0.756 MA/m) as sensing layer material and the other with Co material (Ms=1.44 MA/m) as sensing layer material, for sensor with similar electrical diameter (52 and 58nm respectively) with the proposed embodiment of Figure 5. For the case of a sensing layer made of cobalt, very large fields up to more than 200mT can be achieved without annihilation of the vortex state.

Another advantage of the vortex sensor according to the invention compared to prior art vortex sensors is its reduced hysteresis. Indeed, in prior art vortex-sensors sensitive to in-plane field, the presence of defects at the interface between the vortex sensing layer and the tunnel barrier that are randomly distributed, modify the vortex core displacement path, as the vortex core gets randomly trapped into energy wells associated with such defects. This effect is particularly pronounced in prior art vortex sensor because the vortex core is very narrow (exchange length~5nm) so that the vortex core can easily get trapped by such small defects. In magnetic tunnel junctions, these defects can be due to spatial variations over the MgO/FeCoB interface, of oxygen concentration or Boron concentration or to the diffusion towards the MgO interface of third elements present in the stack such as Ta, Mn, W or Mo. These defects can induce local variations of anisotropy energy which then act as trapping centers for the vortex core. Figure 12 a shows a plan view of the prior art sensing layer comprising defects 30. When the vortex core 31 moves in a first displacement direction 32, it is trapped into (then de-trapped from) the defects 30 encountered in the path of displacement. Similarly, the vortex core 31 moving in a second displacement direction 33 is trapped into (and de-trapped from) the defects 30 encountered in the path of displacement. Depending on its position at nucleation, the vortex core 31 can be trapped and de-trapped in different defects 30 when moving in the first displacement direction 32 than when moving in the second displacement direction 33. Due to this trapping / de-trapping into different defects, the vortex core 31 may follow different paths in the first and second displacement directions. In such a prior art sensor, the vortex core following different paths in the first and second displacement directions results in different magnetization distributions of its magnetization and thus, different resistances of the magnetic sensor at each value of the external applied in-plane magnetic field H.

As a result of this trapping, the transfer curve (Mx versus Hx) can be different depending on the followed path, leading to different resistances of the sensor at each value of external field as shown by S.Dounia, C.Baraduc, and B. Dieny, 2020, EP. Patent No.19315026.5.

In contrast, the sensor according to the invention is much less sensitive to the presence of such defects and their trapping. Indeed, the vortex core does not move laterally in the sensor of the invention: it only expands or shrinks while the curled magnetization in the outer part of the device is reversibly pulled out-of-plane or come back to the in-plane direction under the influence of the out-of-plane field to be sensed. Therefore, the vortex deformation under magnetic field is much more reversible with the sensor of the invention than in prior art vortex sensor as schematically depicted in Figure 12 b. This yields a significantly reduced noise in the sensor of the invention.

In an embodiment of the sensor of the invention, the reference layer and the associated SAF layer can be compensated, meaning that they exert no field or only a very small field (i.e., a field negligible against the field required to reverse the vortex core polarity). In such a case, a possible drawback of the sensor of the invention could be a change of vortex core polarity when a magnetic field larger than the annihilation field is applied in the direction opposite to the vortex core polarity. Such change in vortex polarity would produce an undesired hysteresis as already observed in figure 8 and as illustrated in Figure 13a. Such hysteresis never appears if the sensor is always operated under the same field polarity (minor loops represented in black). However, if the vortex core polarity is changed, a certain difference in resistance between the two states (A, B) at zero field ($\Delta$R) may appear. Such difference in resistance ($\Delta$R) is well observed if one goes through the whole cycle (0.04T to -0.04T). If starting from a positive field larger than the annihilation field (H>+Ha) and decreasing the field to zero, the vortex core exhibits a positive polarity (A, vortex core up). In contrast, if starting from a negative field larger in absolute value than the annihilation field and decreasing the field to zero, (see grey line Fig 13a), the vortex polarity is reversed (B, vortex core down). This results in the observed difference in resistance $\Delta$R at zero applied field.

This problem can be avoided by limiting the range of fields to which the sensor is exposed. The field values should remain below the vortex annihilation field. However, a risk of accidental switching of the vortex core polarity still exists in this case if the sensor is accidentally exposed to an excessively large field.

To better circumvent this issue of accidental switching of the vortex core polarity, a second embodiment is proposed in which the reference layer is coupled to an associated PMA multilayer or a SAF layer, said reference layer and said PMA multilayer (or respectively said reference layer and said SAF layer) being uncompensated. As a result, they create an out-of-plane stray field on the sense layer magnetization. Thanks to this out-of-plane stray field, the vortex always nucleates back with the same polarity, independently of the saturation field direction (positive or negative). This yields the optimal response, which is shown in Figure 13b. Noteworthy, this stray field only translate into a weak asymmetry of the annihilation fields for opposite fields, which can be explained by the large volume of the sensing layer.

Such a sensor 200 with a reference layer and PMA multilayer that are not compensated is illustrated in figure 14a schematically and in figure 14b with more details.

Said sensor 200 is a magnetic stack successively including:

-    a seed layer 201;
-    a multilayer with Perpendicular Magnetic Anisotropy PMA material 202;
-    a texture breaking layer 203;
-    a reference layer 204;
-    a spacer 205 that may be either a tunnel barrier when the sensor is a magnetic tunnel junction or a non-magnetic metallic spacer when the sensor is a metallic spin-valve;
-    a sensing layer 206 which is spontaneously in magnetic vortex configuration in the absence of applied magnetic field;
-    a capping layer 207.

Except the PMA multilayer 202, the other layers 201, 203, 204, 205, 206 and 207 can be identical to the layers illustrated in the sensor of figures 3 and 5.

As mentioned above, in this case, the reference layer does not have to be coupled to a SAF layer as in figures 3 and 5. Rather, the reference layer 204 is coupled to a single high PMA material 202. Such high PMA material can be made of Co/Pt or of Co/X repeats, where X represents Pd, Ni or Ir which are known to provide large PMA values. Alloys such as CoPt, CoPd or FePt or FePd ordered alloys or some rare-earth transition alloys such as TbCo, TbFe can also provide strong PMA. The number of repeats in (Co/Pt) multilayers or the thickness of the alloy can be adjusted to provide sufficient stray field so that the vortex always nucleates with the same polarity, but not too high so that the response remains symmetric when a positive or negative field is applied to the sensor. For (Pt/Co) multilayers, a number n of repeats between 1 and 6 in the PMA multilayer may be advantageously used.

Another possible embodiment aiming at stabilizing the vortex core polarity consists in coupling the sensing layer to an antiferromagnetic layer to provide an out-of-plane exchange bias to the vortex core. Such a sensor 300 is illustrated in figure 15a schematically and with more details in figure 15b.

Said sensor 300 is a magnetic stack successively including:

-    a seed layer 301;
-    a SAF layer 302;
-    a texture breaking layer 303;
-    a reference layer 304;
-    a spacer 305 that may be either a tunnel barrier when the sensor is a magnetic tunnel junction or a non-magnetic metallic spacer when the sensor is a metallic spin-valve;
-    a sensing layer 306 which is spontaneously in magnetic vortex configuration in the absence of applied magnetic field;
-    an exchange biasing layer 308;
-    a capping layer 307.

Except the added exchange biasing layer 308, the other layers 301, 302, 303, 304, 305, 306 and 307 can be identical to the respective layers 101, 102, 103, 104, 105, 106 and 107 illustrated in the sensor of figures 3 and 5.

The exchange biasing layer 308 is above and in contact with the vortex sensing layer 306. Said exchange biasing layer 308, made of an antiferromagnetic material (AF) such as iridium manganese (IrMn) or platinum manganese (PtMn) alloys at the interface of the sensing layer opposite to the tunnel barrier, can be used for this purpose. A unidirectional magnetic anisotropy arises at the interface between the ferromagnetic sensing layer 306 and the AF layer 308, caused by the exchange coupling between the two layers. To provide the exchange bias, the stack must be annealed above the antiferromagnetic layer blocking temperature and cooled down in a magnetic field in the field direction perpendicular to the plane of the layers. As well known by the man skilled in the art, the intensity of the exchange bias can be adjusted by inserting at the interface between the sensing layer 306 and the antiferromagnetic layer 308 a thin layer (not represented) of a non-magnetic element such as Cu, W, Mo or Ta. The main advantage of the sensor of Figure 15 is that the single vortex polarity stabilization does not result from the stray field from the reference layer, which may be difficult to control in practice, due to its variability with the junction dimension, but only from the exchange with an antiferromagnetic layer grown in contact with the sensing layer. The use of such an AF layer is quite common in spintronic sensors, since the reference layer of conventional sensors is typically pinned by exchange biasing with such AF structure, in the plane of the layers.

Figure 16 shows an embodiment of a sensing device D. D comprises a Wheatstone bridge arrangement with four magnetoresistive sensors R1, R2, R3 and R4, each sensor being a sensor according to the invention.

The sensing device D in Wheatstone bridge configuration comprises four elementary sensors R1, R2, R3 and R4 of the invention configured so that R1 and R4 have their reference layer and vortex core magnetization in the sensing layer oriented in a first out-of-plane direction while R2 and R3 have their reference layer and vortex core magnetization in the sensing layer oriented in the opposite out-of-plane direction.

The sensors R1 and R4 have each an inverse response compared to the sensors R2 and R3. In other words, R1 and R4 (sensors located on opposite branches) have the same response and have their reference layer and vortex core magnetization in the sense layer oriented in a first out-of-plane direction while R2 and R3 have also the same response and their reference layer and vortex core magnetization in the sense layer oriented in the opposite out-of-plane direction.

A sense current is supplied between contacts C1 and C2, $I_{in}$ representing the entering current into the bridge and $I_{out}$ the outgoing current. In such Wheatstone bridge configuration D, the elementary sensors are configured so that under an applied magnetic field to be sensed, the resistances of two of the elementary sensors located on opposite branches (here R1 and R4) increases (respectively decreases) while the resistance of the two other sensors (in that example R2 and R3) decreases (respectively increases). Advantageously, this makes it possible to measure a potential difference Voutput between the two contacts C3 and C4, which is directly related to the external out-of-plane magnetic field to be sensed. According to the embodiment of figure 16, it is possible to start with four sensors R1, R2, R3, R4 having the same stack of layers (i.e., realized on the same wafer with same technology and the same geometry and materials). To configure these elementary sensors in order to get opposite responses of the group of sensors R1 and R4 versus the group of sensors R2 and R3, one possibility is to use a combined influence of Joule heating and application of an external magnetic field. Preferably, the magnetic tunnel junctions are chosen with a resistance area product (RA) relatively high, typically above $100\,\Omega.\mu m^2$. This allows to reduce the power consumption of the sensor and increase the tunnel magnetoresistance amplitude. Also, the reference layer is chosen to have an uncompensated reference layer so that the stray field from the reference layer is large enough to maintain the vortex core magnetization always parallel to that of the reference layer magnetization. Then, to initialize the Wheatstone bridge configuration, an out-of-plane field is first applied, large enough to fully saturate the magnetization of all layers in a first out-of-plane direction (for instance upwards). Then a current is sent between contacts C1 and C3 and between contacts C4 and C2 in order to produce Joule heating in the sensors R1 and R4. This Joule heating which increases the junction's temperature by typically 80°C to 200°C reduces the coercive field of the reference layer and of the vortex core magnetization in those two sensors R1 and R4. While the junctions are heated, a field opposite in direction to the first direction of the initial saturation field is applied, with an amplitude sufficiently large to switch the reference layer magnetization and the vortex core magnetization in sensors R1 and R4 but low enough not to switch the magnetization of the sensors R2 and R3 which remain at the standby temperature. Finding such intermediate field amplitude is possible thanks to the variation of the coercive field with temperature in this type of sensors. As a result of this initialization procedure, the four magnetic sensors comprised in the bridge will end up in magnetic configurations as represented in Fig.16. The reference layer magnetizations in R2 and R3 are still in the up direction while the reference layer magnetizations in R1 and R4 are in the down direction and the vortex core magnetization of the sense layer in all junctions is parallel to their respective reference layer magnetization. Then, under application of a field to be sensed, the vortex core of the sensors whose magnetization is parallel to the applied field will widen while the vortex core of the sensors whose magnetization is antiparallel to the applied field will shrink. For the former junctions, this will yield a decrease of their resistance while for the latter, this will yield an increase of the resistance. The unbalance of the Wheatstone bridge will therefore significantly vary with the applied field thus producing the sensor output signal Voutput.

In an alternative embodiment, the sensors R1, R2, R3, R4 can be formed by several individual sensors connected in series or in parallel. In that case, all the individual sensors constituting one of the resistances Ri (i from 1 to 4) will be configured identically by just applying a saturation field in the up or in the down direction.

Of course, the sensor according to the invention is not limited to the embodiments that have just been described for indicative and in no way limiting purposes with reference to the figures.

In all the above disclosed embodiments, the sensors according to the invention is of the "bottom" configuration, meaning that the sensing layer is above the tunnel barrier and the reference layer is below the tunnel barrier. However, the invention is of course not limited to a "bottom" configuration; the sensor of the invention may be alternatively in the "top" configuration. This means that the stack may be grown in bottom pinned or top pinned configuration i.e. the sensing layer can be above or below the tunnel junction while correspondingly the reference layer is below or above the tunnel barrier. Since the sensing layer is preferably rather thick in the sensor, it may be advantageous to grow it above the tunnel barrier in order not to create a large roughness for the growth of the tunnel barrier.

Besides, while the detailed embodiments of the sensor according to the invention have been made for a sensor based on magnetic tunnel junction, the man skilled in the art knows that the embodiments described above can also be adapted to the case of a fully metallic magnetoresistive sensor based on giant magnetoresistance. In this case, the tunnel barrier would be replaced by a non-magnetic metallic spacer such as Cu. From a material point of view, these metallic stacks are easier since all the involved material can have an fcc structure so fewer materials issues need to be considered than in magnetic tunnel junctions where some parts of the stack are fcc while others are bcc.

Moreover, the detailed embodiments have been disclosed assuming that the sensor of the invention has a cylindrical shape with a circular cross-section so that the sensing layer dimensions were characterized by its diameter and thickness. The invention would however apply for any type of shape which allows stabilizing the vortex configuration of the sense layer. This is among other true for square shape, square shape with rounded corners, slightly rectangular shape (long side not exceeding twice the short side) possibly with rounded corners, elliptical shape with moderate ellipticity (not exceeding a ratio of 2 between long axis and short axis) or any other shape in which the vortex state can be stabilized. For all these shapes, the sense layer aspect ratio is defined by the ratio of its thickness by the shortest in-plane dimension. If the sense layer has a disk shape, this characteristic dimension is its diameter. If it is a square or close to a square, this is the length of the square side. If it is a rectangle, it is the short side of the rectangle. For an ellipse, it is the short axis.

These devices can be fabricated using a manufacturing process very similar to that of prior art TMR sensors. This process involves the steps of depositing all the layers by physical vapor deposition, etching the sensing layer by reactive or ion beam etching and etching the other layers by ion beam etching. In this process, it is known that ion beam etching of magnetic material often leads to tapered pillars especially in the present case where pillars of high aspect ratio are etched. The presence of such tapered shape is acceptable and will not hamper the working principle of the sensor.

Besides, as well known by the man skilled in the art, several sensors of the invention can be connected in series and/or in parallel to increase the signal to noise ratio of the overall sensor.

**Claims**

1. Magnetoresistive sensor (100, 200, 300) sensitive to an out-of-plane applied magnetic field comprising:

   - a sensing layer (106, 206, 306);
   - a reference layer (104, 204, 304) with a fixed magnetization, the direction of said fixed magnetization being perpendicular to the plane of said reference layer;
   - a non-magnetic spacer layer (105, 205, 305) separating said sensing layer (106, 206, 306) and said reference layer (104, 204, 304);

   said sensing layer (106, 206, 306) having a magnetization vortex configuration in the absence of an applied magnetic field, the vortex core diameter varying in the presence of an applied magnetic field perpendicular to the plane of said reference layer (104, 204, 304).

2. Magnetoresistive sensor according to claim 1 **characterized in that** the sensing layer is chosen with an aspect ratio defined as the thickness of the sensing layer divided by the in-plane characteristic dimension of the sensing layer comprised between 0.2 and 2.

3. Magnetoresistive sensor according to claim 2 **characterized in that** said aspect ratio is comprised between 0.2 and 1.

4. Magnetoresistive sensor according to any of the previous claims **characterized in that** the non-magnetic spacer layer is a tunnel barrier layer or a metallic spacer.

5. Magnetoresistive sensor according to any of the previous claims **characterized in that** the reference layer is magnetically coupled to a synthetic antiferromagnetic layer with perpendicular anisotropy.

6. Magnetoresistive sensor according to any of the previous claims **characterized in that** the non-magnetic spacer layer is a tunnel barrier layer and the sensing layer comprises a first layer made of an alloy based on iron, cobalt and an amorphising element, said first layer being in contact with the tunnel barrier layer.

7. Magnetoresistive sensor according to claim 6, **characterized in that** the sensing layer comprises at least another layer of material adapted to absorb at least part of the amorphising element present in the first layer and to ensure a structural transition between the layers comprised in the sensing layer.

8. Magnetoresistive sensor according to claim 7, **characterized in that** the material adapted to absorb the at least part of the amorphising element is chosen among the following materials: Ta, Mo, W, or Hf or a mixed of them.

9. Magnetoresistive sensor according to any of the previous claims **characterized in that** the sensing layer comprises one or several laminations of oxide layers.

10. Magnetoresistive sensor according to any of the previous claims **characterized in that** it comprises an arrangement of one or more layers avoiding switching of the vortex core magnetization direction.

**11.** Magnetoresistive sensor according to any of the previous claims **characterized in that** the reference layer is magnetically coupled to a layer made in a hard material with perpendicular anisotropy.

**12.** Magnetoresistive sensor according to any of the previous claims **characterized in that** it comprises an antiferromagnetic layer inducing a perpendicular exchange bias on the sensing layer, said antiferromagnetic layer being magnetically coupled to the sensing layer.

**13.** Magnetoresistive sensor according to claim 12 **characterized in that** it comprises a non-magnetic spacer layer between the sensing layer and the antiferromagnetic layer inducing a perpendicular exchange bias on the sensing layer magnetization in order to tune the exchange bias coupling strength.

**14.** Magnetoresistive sensor according to any of the previous claims **characterized in that** the geometry and the dimensions of the vortex sensing layer are chosen such that the vortex configuration of the sensing layer is not annihilated over a range of applied magnetic field to be sensed of at least + or - 200 mT.

**15.** Sensing device **characterized in that** it comprises a plurality of magnetoresistive sensors according to any of the previous claims that are electrically coupled in series and/or in parallel.

**16.** Sensing device according to claim 15 comprising four magnetoresistive sensors according to any of the claims 1 to 14, said four magnetoresistive sensors being arranged according to a Wheatstone bridge configuration and configured so that the reference layer of the two sensors located in the two opposite branches of the bridge are magnetized in a first out-of-plane direction while the reference layer of the two magnetoresistive located in the two other branches of the bridge are magnetized in the opposite out-of-plane direction.

1

| CAP | 6 |
| Vortex sensing layer | 5 |
| Tunnel barrier / metal | 4 |
| 10    reference | |
| 9    Ru | 3 |
| 8    FM | |
| 7    AF | |
| Seed layer | 2 |

Prior art

# Fig. 1

D

z
y    x

t

$H_x$

$M_x$

$H_a$

$H_x$

$H_n$

A

B

C

C:    y    x

Vortex core

A:

B:    $\Delta d$

Vortex core

Vortex core

# Fig. 2

**Fig. 3**

**Fig. 4**

Fig. 5

Fig. 6

**Fig. 7**

**Fig. 8**

**Fig. 9**

**Fig. 10**

**Fig. 11**

Vortex core
displacement
(a)

Vortex core
expansion
(b)

# Fig. 12

Fig. 13

**Fig. 14**

(a)

| | |
|---|---|
| 207 | CAP |
| 206 | Vortex sensing layer |
| 205 | Tunnel barrier / metal |
| 204 | Reference ↑ |
| 203 | Amorphising element absorber+ structural transition |
| 202 | PMA material ↑↓ |
| 201 | Seed layer |

(b)

| Pt 3 | CAP 207 |
| Ta 1 | |
| NiFe 58 | Vortex sensing layer 206 |
| Ta 0.2 | |
| FeCOB 1.4 | |
| MgO 1.2 | Tunnel barrier / metal 205 |
| FeCoB 1.0 | Reference 204 |
| Ta 0.2 | Amorphising element 203 absorber |
| nx(Pt 0.25/Co 0.5) | High PMA Material 202 |
| Pt 25 | |
| Ta 3 | Seed layer 201 |

**Fig. 15**

(a)

| | |
|---|---|
| 307 | CAP |
| 308 | Exchange biasing layer |
| 306 | Vortex sensing layer |
| 305 | Tunnel barrier / metal |
| 304 | Reference ↑ |
| 303 | Amorphising element absorber+ structural transition |
| 302 | SAF ↑↓ |
| 301 | Seed layer |

(b)

| Pt 3 | CAP 307 |
| Ta 1 | |
| IrMn 6 | Exchange biasing layer 308 |
| NiFe 58 | Vortex sensing layer 306 |
| Ta 0.2 | |
| FeCoB 1.4 | |
| MgO 1.2 | Tunnel barrier / metal 305 |
| FeCoB 1.0 | Reference 304 |
| Ta 0.2 | Amorphising element absorber+structural transition 303 |
| 3x(Pt 0.25/Co 0.5) | |
| Co 0.5 | Synthetic antiferromagnet 302 (SAF) |
| Ru 0.9 | |
| Co 0.5 | |
| 4x(Co 0.5/Pt 0.25) | |
| Pt 25 | Seed layer 301 |
| Ta 3 | |

**Fig. 16**

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E | EP 4 012 431 A1 (CROCUS TECH S A [FR]) 15 June 2022 (2022-06-15) * paragraphs [0001], [0007], [0009], [0012]; figure 1 * | 1-5 | INV. G01R33/12 |
| Y | US 2017/168122 A1 (RABERG WOLFGANG [DE] ET AL) 15 June 2017 (2017-06-15) * paragraphs [0012], [0024], [0039], [0046], [0049], [0053] – [0055], [0060]; figures 1,12 * * paragraphs [0073], [0074], [0087]; figure 7 * | 1,5, 12-16 | |
| Y | US 2021/382123 A1 (KUBOTA MASASHI [JP] ET AL) 9 December 2021 (2021-12-09) * paragraphs [0001], [0013], [0017] – [0020], [0113], [0195]; figures 16,17,18 * | 1,5, 12-16 | |
| A | US 2011/102939 A1 (KAWAKAMI HARUO [JP] ET AL) 5 May 2011 (2011-05-05) * paragraphs [0034], [0042] – [0051], [0064], [0067], [0072] * | 1-16 | TECHNICAL FIELDS SEARCHED (IPC)  G01R |

The present search report has been drawn up for all claims

| Place of search | Date of completion of the search | Examiner |
|---|---|---|
| Munich | 29 September 2022 | Loughman, John |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 22 30 5459

This annex lists the patent family members relating to the patent documents cited in the above-mentioned European search report.
The members are as contained in the European Patent Office EDP file on
The European Patent Office is in no way liable for these particulars which are merely given for the purpose of information.

29-09-2022

| Patent document cited in search report | | Publication date | Patent family member(s) | | Publication date |
|---|---|---|---|---|---|
| EP 4012431 | A1 | 15-06-2022 | EP | 4012431 A1 | 15-06-2022 |
| | | | WO | 2022123472 A1 | 16-06-2022 |
| US 2017168122 | A1 | 15-06-2017 | CN | 107046095 A | 15-08-2017 |
| | | | DE | 102015121753 A1 | 14-06-2017 |
| | | | JP | 6355706 B2 | 11-07-2018 |
| | | | JP | 2017112375 A | 22-06-2017 |
| | | | US | 2017168122 A1 | 15-06-2017 |
| US 2021382123 | A1 | 09-12-2021 | CN | 113574694 A | 29-10-2021 |
| | | | DE | 112020001831 T5 | 23-12-2021 |
| | | | JP | 7136340 B2 | 13-09-2022 |
| | | | JP | WO2020208907 A1 | 11-11-2021 |
| | | | US | 2021382123 A1 | 09-12-2021 |
| | | | WO | 2020208907 A1 | 15-10-2020 |
| US 2011102939 | A1 | 05-05-2011 | EP | 2320489 A1 | 11-05-2011 |
| | | | JP | 5354389 B2 | 27-11-2013 |
| | | | JP | WO2010007695 A1 | 05-01-2012 |
| | | | KR | 20110050582 A | 16-05-2011 |
| | | | US | 2011102939 A1 | 05-05-2011 |
| | | | WO | 2010007695 A1 | 21-01-2010 |

EPO FORM P0459

For more details about this annex : see Official Journal of the European Patent Office, No. 12/82

## REFERENCES CITED IN THE DESCRIPTION

**Patent documents cited in the description**

- EP 19315026, S.Dounia, C.Baraduc, and B. Dieny

**Non-patent literature cited in the description**

- **P. P. FREITAS ; R. FERREIRA ; S. CARDOSO.** Spintronic Sensors. *Proceedings of the IEEE,* 2016, vol. 104 (10), 1894-1918
- **SUESS, D. ; BACHLEITNER-HOFMANN, A. ; SATZ, A. et al.** Topologically protected vortex structures for low-noise magnetic sensors with high linear range. *Nat Electron,* 2018, vol. 1, 362-370
- **METLOV,K. L. ; LEE Y.** Map of metastable states for thin circular magnetic nanocylinders . *Appl. Phys. Lett.,* 2008, vol. 92, 112506